(19) Europäisches Patentamt
European Patent Office
Office européen des brevets

(11) **EP 3 624 169 B1**

(12) **FASCICULE DE BREVET EUROPEEN**

(45) Date de publication et mention
de la délivrance du brevet:
**02.08.2023 Bulletin 2023/31**

(21) Numéro de dépôt: **19194092.3**

(22) Date de dépôt: **28.08.2019**

(51) Classification Internationale des Brevets (IPC):
**H01L 21/02** (2006.01)     **H01L 21/762** (2006.01)

(52) Classification Coopérative des Brevets (CPC):
**H01L 21/7624; H01L 21/02052**

(54) **PROCEDE POUR LE TRAITEMENT D'UN SUBSTRAT SOI DANS UN EQUIPEMENT DE NETTOYAGE MONOPLAQUE**

**VERFAHREN ZUR BEHANDLUNG EINES SOI-SUBSTRATES IN EINER EINPLATTEN-REINIGUNGSANLAGE**

**PROCESS FOR TREATING A SOI SUBSTRATE IN A SINGLE PLATE CLEANING EQUIPMENT**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **11.09.2018 FR 1858118**

(43) Date de publication de la demande:
**18.03.2020 Bulletin 2020/12**

(73) Titulaire: **Soitec**
**38190 Bernin (FR)**

(72) Inventeurs:
• **VIRAVAUX, Laurent**
**38700 CORENC (FR)**
• **LEDRAPPIER, Sébastien**
**38700 LA TRONCHE (FR)**

(74) Mandataire: **IP Trust**
**2, rue de Clichy**
**75009 Paris (FR)**

(56) Documents cités:
**US-A1- 2002 062 840     US-A1- 2005 115 671**
**US-A1- 2012 160 275**

• **MASANOBU SATO ET AL: "Analysis on Threshold Energy of Particle Removal in Spray Cleaning Technology", ECS TRANSACTIONS, 1 janvier 2011 (2011-01-01), pages 75-82, XP055589550, US ISSN: 1938-5862, DOI: 10.1149/1.3630829**

**Description**

**DOMAINE DE L'INVENTION**

La présente invention concerne le domaine de la microélectronique. Elle concerne en particulier un procédé de nettoyage de substrats SOI (« Silicon on Insulator »), utilisant un équipement de nettoyage monoplaque.

**ARRIERE PLAN TECHNOLOGIQUE DE L'INVENTION**

Les équipements de nettoyage monoplaque (appelés « SWC » pour « single wafer cleaner » selon la terminologie anglo-saxonne) sont couramment utilisés dans les procédés microélectroniques pour leurs hautes performances de nettoyage des plaques de grands diamètres (notamment 300mm). En effet, ils permettent de limiter certaines défectivités en bords de plaques, souvent associées aux équipements de nettoyage par lots, fonctionnant avec des séquences d'immersion dans des bains chimiques. Les risques de contamination croisée entre plaques d'un même lot sont également moindres dans des équipements de nettoyage monoplaque. Enfin, ces équipements permettent une plus grande flexibilité dans le choix des séquences de nettoyage, qui peuvent être, le cas échéant, adaptées à chaque plaque.

Les documents US2002062840 A1, US2012160275A1 et US2005115671A1 décrivent de tels équipements de traitement chimique monoplaque, en particulier destinés à traiter des substrats semi-conducteurs structurés au cours de l'élaboration de composants microélectroniques. M.Sato et al (« Analysis on threshold energy of particle removal in spray cleaning technology », ECS Transactions, 41(5) 75-82 (2011)) précise en outre que les structures en résine photosensible (« photoresist patterns ») peuvent être endommagées si la densité d'énergie des gouttelettes lors d'un nettoyage par « spay » excède un certain seuil.

En général, dans un équipement monoplaque, la plaque est maintenue par des doigts sur sa périphérie et animée par un mouvement de rotation au cours des différentes séquences de nettoyage ou d'amincissement (gravure chimique). Des bras de dispense de solutions chimiques et/ou de solutions de rinçage sont configurés pour se déplacer au-dessus de la plaque ; la solution dispensée s'étend par centrifugation sur toute la surface de la plaque et est éjectée en bord de plaque. Une pluralité de bols, de forme tronconique, disposés dans un espace périphérique à la plaque, permet de récupérer sélectivement les solutions chimiques, dispensées consécutivement lors des séquences de nettoyage ou d'amincissement. Les bols sont aptes à changer d'altitude par rapport à la plaque, ainsi chaque bol peut être positionné de manière à récupérer une solution particulière lorsqu'elle est éjectée en bord de plaque, ce qui évite le mélange de solutions chimiques incompatibles.

Un équipement monoplaque peut par exemple être mis en oeuvre pour le nettoyage et/ou l'amincissement final de la couche superficielle de silicium d'une plaque SOI, et en particulier d'une plaque FDSOI (« Fully Depleted SOI »), présentant une couche de silicium très mince (typiquement, entre quelques nanomètres et quelques dizaines de nanomètres).

La demanderesse a observé une augmentation de 500% de la quantité de défauts HF sur des plaques FDSOI dont la couche de silicium superficielle présente une épaisseur de l'ordre de 10 à 12 nm, subissant un nettoyage final sur un équipement de nettoyage monoplaque, comparativement à un nettoyage similaire dans un équipement multi-plaque à bains chimiques (environ 2 défauts /plaque) . Même si ces chiffres sont susceptibles de varier en fonction des propriétés de la couche superficielle, l'augmentation des défauts HF reste significative et il apparaît nécessaire d'améliorer les procédés de nettoyage ou de gravure de substrats SOI sur un équipement monoplaque.

Rappelons qu'un défaut HF correspond à une dégradation en surface ou dans le volume de la couche superficielle de silicium, donnant naissance à un chemin d'accès à travers ladite couche superficielle jusqu'à la couche d'oxyde sous-jacente du substrat SOI. La révélation de ces dégradations se fait par immersion de la plaque dans une solution d'acide fluorhydrique (HF) qui, en pénétrant à travers la couche superficielle, va attaquer la couche d'oxyde et rendre visible le défaut.

**OBJET DE L'INVENTION**

La présente invention vise à pallier tout ou partie des inconvénients précités. Elle concerne un procédé de nettoyage et/ou d'amincissement de plaques SOI sur un équipement monoplaque. L'invention vise en particulier à proposer une solution pour la réduction des défauts HF sur des substrats FDSOI après nettoyage sur un équipement monoplaque.

**BREVE DESCRIPTION DE L'INVENTION**

L'invention concerne un procédé pour le traitement d'un substrat SOI dans un équipement de nettoyage monoplaque, ledit procédé étant défini par les revendications attenantes.

**BREVE DESCRIPTION DES DESSINS**

D'autres caractéristiques et avantages de l'invention ressortiront de la description détaillée qui va suivre en référence aux figures annexées sur lesquelles :

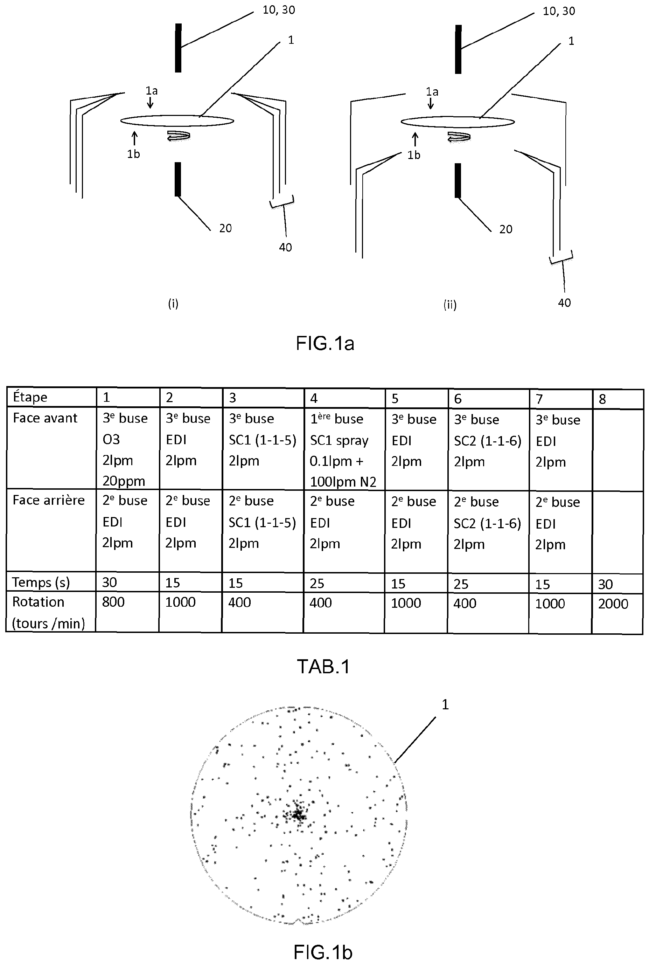

- les figures 1a(i) et 1a(ii) présentent des schémas d'un équipement de nettoyage monoplaque ;
- le tableau 1 présente un traitement standard appliqué à un substrat, dans un équipement de nettoyage monoplaque ;
- la figure 1b présente un empilement de cartographies de la face avant de plusieurs substrats FDSOI traités selon le traitement standard, dans un équipement de nettoyage monoplaque ;

- les tableaux 2, 3 présentent chacun un traitement appliqué à un substrat, dans un équipement de nettoyage monoplaque, respectivement selon un premier et un deuxième mode de réalisation ne faisant pas partie de l'invention.
- le tableau 4 présente un traitement appliqué à un substrat dans un équipement de nettoyage monoplaque selon un mode de réalisation de l'invention.

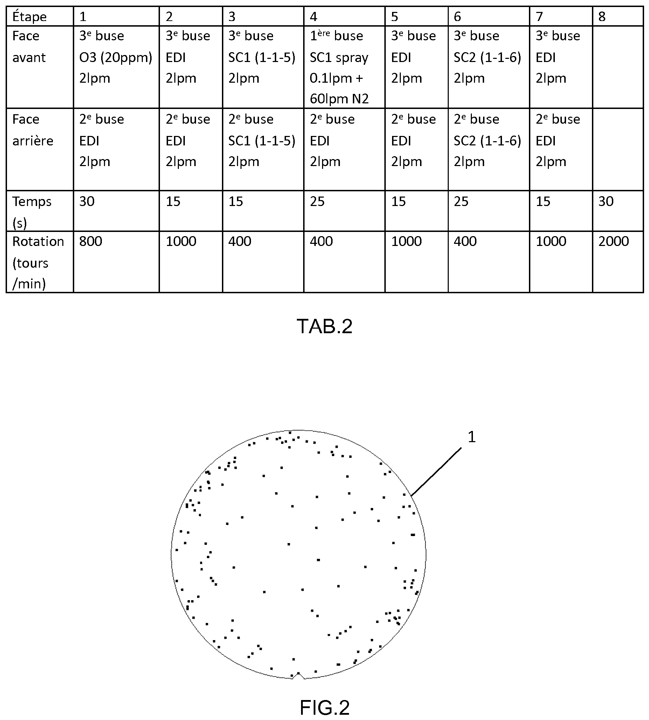

- les figures 2, 3 et 4 présentent chacune un empilement de cartographies de la face avant de plusieurs substrats FDSOI traités respectivement selon le premier et le deuxième mode de réalisation qui ne font pas partie de l'invention, et selon le troisième mode de réalisation du procédé conforme à l'invention ;

**DESCRIPTION DETAILLEE DE L'INVENTION**

L'invention concerne un procédé pour le traitement d'un substrat SOI, dans un équipement de nettoyage monoplaque (SWC).

Un tel équipement comprend une chambre de traitement, dans laquelle se trouve un système de préhension (non représenté) du substrat 1 à traiter. Habituellement, mais de manière non limitative, ledit système comporte au moins trois doigts qui maintiennent mécaniquement le substrat 1 en sa périphérie. Le système de préhension est apte à opérer un mouvement de rotation, qui est transmis au substrat 1 au cours des séquences de traitement.

L'équipement monoplaque comprend également au moins une buse 10,30 pour la dispense d'au moins une solution sur une face avant 1a du substrat 1. Rappelons que la face avant 1a du substrat 1 est la face dite active, en particulier pour un substrat SOI, la face active est la face libre de la couche superficielle de silicium. La buse 10,30 est habituellement supportée par un bras mobile apte à la positionner sensiblement en vis-à-vis du centre du substrat 1 et/ou apte à se déplacer au-dessus du substrat, par exemple en effectuant des allers-retours en arc de cercle. La solution distribuée par la buse 10,30 est répartie sur toute la surface du substrat 1 par centrifugation.

Différents types de solutions liquides peuvent être dispensées sur la face avant 1a du substrat 1. A titre d'exemple, nous pouvons citer des solutions chimiques acides ou basiques (acide fluorhydrique (HF), acide chlorhydrique (HCl), acide sulfurique ($H_2SO_4$), ozone (O3), SC2 - Standard Clean 2 (HCl/H2O2/H2O), SC1 - Standard Clean 1 (NH3/H2O2/H2O)) avec des concentrations variables des composés, ou des solutions de rinçage (eau ultra pure).

Elles peuvent être dispensées sous forme d'un jet liquide à faible ou moyenne pression (typiquement 0,5 à 2,5 l/min) ou sous forme d'un jet de gouttelettes (spray). Le spray est formé par le mélange d'un gaz à haute pression et du liquide de la solution souhaitée à faible pression. Le gaz utilisé est habituellement de l'azote.

Pour la dispense sur la face avant 1a du substrat 1, l'équipement monoplaque comprend en particulier une première buse 10 permettant la dispense d'une première solution sous forme d'un jet de gouttelettes. Dans la suite de cette description, on appellera « première solution » toute solution dispensée sur la face avant 1a du substrat 1 sous forme d'un jet de gouttelettes. La première solution pourra être choisie parmi les différentes solutions liquides précédemment énoncées.

La dispense par spray est classiquement utilisée pour retirer efficacement les contaminations particulaires de la surface du substrat 1. Pour le nettoyage de substrats en silicium, nus ou pourvus de couches homogènes, structurés ou sans structuration, le jet de gouttelettes est habituellement formé par un mélange d'azote, ayant un débit compris entre 0.5 l/min et 250 l/min, et de liquide (ladite première solution, qui pourra par exemple être une solution de SC1) ayant un débit compris entre 50 ml/min et 300 ml/min.

L'équipement monoplaque comprend au moins une buse 20 pour la dispense d'au moins une solution, sur une face arrière 1b du substrat 1, opposée à sa face avant 1a. Cette buse 20 peut être supportée par un bras fixe apte à positionner ladite buse sensiblement en vis-à-vis du centre du substrat 1, au niveau de sa face arrière 1b. Alternativement, le bras peut être mobile, apte à positionner la buse 20 sensiblement en vis-à-vis du centre du substrat 1 et/ou à se déplacer en-dessous du substrat, par exemple en effectuant des allers-retours en arc de cercle. La solution distribuée par la buse 20 est répartie sur toute la face arrière 1b du substrat 1 par centrifugation.

Différents types de solutions liquides peuvent être dispensées sur la face arrière 1b du substrat 1, notamment les solutions précédemment énoncées pour la dispense en face avant 1a. Habituellement, elles sont dispensées sous forme d'un jet liquide à faible ou moyenne pression (typiquement 0,5 à 2,5 l/min).

Pour la dispense sur la face arrière 1b du substrat 1, l'équipement monoplaque comprend donc en particulier une deuxième buse 20 permettant la dispense d'une deuxième solution. Dans la suite de cette description, on appellera « deuxième solution » toute solution dispensée sur la face arrière 1b du substrat 1.

Avantageusement, l'équipement monoplaque comprend au moins une autre buse 30 (appelée « troisième buse ») permettant la dispense, sur la face avant 1a du substrat 1, d'une solution sous forme d'un jet liquide à faible ou moyenne pression. Dans la suite de cette description, on appellera « troisième solution » toute solution dispensée sur la face avant 1a du substrat 1 sous forme d'un jet liquide à faible ou moyenne pression. La troisième solution pourra être choisie parmi les différentes solutions liquides précédemment énoncées.

L'équipement monoplaque comprend une pluralité de bols 40 disposés dans un espace périphérique au substrat 1 (figure 1a(i)) et destinés à récupérer sélectivement les premières, deuxièmes et/ou troisièmes solutions utilisées pour traiter le substrat 1. Chaque bol 40 présente une forme tronconique et est apte à changer d'altitude vis-à-vis du substrat 1 ; chaque bol 40 peut ainsi être positionné de manière à récupérer une solution particulière lorsqu'elle est éjectée en bord de plaque (figure 1a(ii)) .

A titre d'exemple, une séquence de nettoyage de type :

- Ozone (O3)

- Rinçage (EDI pour eau désionisée)

- SC1 ou SC2

- SC1 spray (dispense sous forme de jet de gouttelettes)

- Rinçage (EDI)

- SC2

- Rinçage (EDI)

peut être utilisée pour nettoyer les contaminations organiques, particulaires et métalliques de substrats SOI. Le tableau 1 présente les paramètres standard d'une telle séquence selon l'état de la technique, par exemple appliquée à des substrats de silicium nus ou pourvus de couches homogènes (telles que des oxydes par exemple). Les proportions des différents constituants NH3/H2O2/H2O pour le SC1 et HCl/H2O2/H2O pour le SC2 sont notés entre parenthèses dans le tableau 1, ainsi que le ou les débits au niveau des première 10, deuxième 20 et troisième 30 buses.

Lors des étapes 1, 2, 3, 5, 6 et 7, la dispense en face avant 1a du substrat 1 est effectuée à partir de la troisième buse 30, sous forme de jet liquide à faible ou moyenne pression (débit de l'ordre de 2 litres par minute).

Lors de l'étape 4, la solution SC1 est dispensée sous forme d'un jet de gouttelettes à partir de la première buse 10 ; le jet de gouttelettes (spray) est formé à partir du mélange de la première solution (SC1 dans cet exemple) dont le débit est de 0,05 litre par minute, et d'azote gazeux dont le débit est de 100 litres par minute.

La demanderesse a appliqué cette séquence standard à des substrats SOI 1, dans l'équipement monoplaque. Comme cela est bien connu en soi, un substrat SOI comporte une couche superficielle de silicium et une couche d'oxyde de silicium enterré, disposés sur un substrat support. Un substrat SOI peut être fabriqué à partir du procédé Smart-Cut™, basé sur une implantation d'ions légers d'hydrogène et/ou d'hélium dans un substrat donneur et un collage par exemple par adhésion moléculaire de ce substrat donneur sur le substrat support, une couche d'oxyde de silicium étant intercalée entre les deux substrats. Une étape de détachement permet ensuite de séparer une couche mince superficielle du substrat donneur, au niveau du plan de fragilisation défini par la profondeur d'implantation des ions. Des étapes de finition, pouvant inclure des traitements thermiques à haute température, confèrent enfin la qualité cristalline et de surface requise à la couche active. Ce procédé est particulièrement adapté pour la fabrication de couches superficielles de silicium très minces. Les étapes de finition du substrat SOI incluent également des séquences de nettoyage et/ou d'amincissement de la couche superficielle de silicium.

En particulier, la séquence standard a été appliquée à des substrats FDSOI comportant une couche superficielle de silicium et un oxyde de silicium enterré présentant respectivement une épaisseur de 10 nm et de 30 nm.

Une telle séquence de nettoyage permet, comme sur des substrats de silicium, de nettoyer la face avant 1a et la face arrière 1b du substrat SOI 1 ; elle peut également permettre d'amincir la couche superficielle de silicium de quelques nanomètres, lors de la dispense de la solution SC1 sur la face avant 1a, pour retirer des imperfections superficielles ou atteindre une épaisseur de couche précise.

La figure 1b présente un empilement de cartographies de face avant 1a d'une trentaine de substrats FDSOI, après traitement selon la séquence standard dans l'équipement monoplaque et après révélation de défauts HF. Le nombre moyen de défauts HF (représentés par des points sur la cartographie empilée) sur chaque plaque est environ 5 fois supérieur après traitement, comparativement à un traitement similaire dans un équipement multi-plaques à bains chimiques.

Notons que les cartographies sont obtenues à partir d'instruments de mesure de défectivité (seuil 0,1 micron) basés sur la microscopie par réflexion en champ sombre, de type KLA-TENCOR Surfscan SP (marque déposée).

Le procédé de traitement selon l'invention est remarquable en ce que l'étape de dispense par spray d'une première solution sur la face avant du substrat FDSOI est opérée de sorte que l'énergie cinétique surfacique (ou densité surfacique d'énergie) des gouttelettes du spray soit inférieure ou égale à 30 Joules/m$^2$. Cette énergie cinétique surfacique correspond à l'énergie délivrée par une gouttelette 1 au moment de l'impact sur la plaque 1. On l'évalue à partir de l'équation suivante :

$$E = \frac{mv^2}{2\pi r^2}$$

Avec m la masse de la gouttelette, v sa vitesse, r son rayon.

On pourra se référer aux systèmes et techniques connus de l'état de la technique permettant de caractériser la vitesse d'éjection d'une gouttelette en sortie d'un spray.

Par exemple, dans l'équipement monoplaque utilisé ici, avec un débit d'azote 45 litres par minute pour la dispense par spray, l'énergie cinétique de la gouttelette est d'environ 3.35E-9 J. La surface d'impact de la gouttelette est de l'ordre de 3.14E-10m². On a donc une densité surfacique d'énergie de l'ordre de 10 J/m².

En effet, la demanderesse a observé que la projection de ces gouttelettes sur la face avant 1a d'un substrat SOI 1 était susceptible d'endommager mécaniquement la couche superficielle de silicium, d'autant plus que l'épaisseur de cette couche est fine, en particulier pour des épaisseurs inférieures à 50nm. L'endommagement se traduit par des micro-trous ou des défauts cristallins traversant la couche superficielle de silicium, lesquels sont à l'origine de l'augmentation de défauts HF.

Le tableau 2 présente les paramètres principaux d'un premier mode de réalisation ne faisant pas partie de l'invention. A l'étape 4, la première solution SC1 est dispensée sous forme d'un jet de gouttelettes formé à partir du mélange de :

- ladite première solution dont le débit est compris entre 0,1 litre par minute et 0,2 litre par minute, préférentiellement entre 0,15 et 0,2 litre par minute,
- et d'azote gazeux dont le débit est inférieur ou égal à 70 litres par minute, préférentiellement inférieur ou égal à 60 litres par minute.

Dans cette configuration, l'énergie cinétique surfacique des gouttelettes arrivant sur la face avant 1a du substrat SOI 1 est inférieure ou égale à 30 Joules/m², ce qui évite ou diminue nettement l'endommagement de la couche superficielle de silicium.

On prend ici l'exemple d'une dispense par spray d'une première solution de type SC1, mais la nature de la solution est indifférente et pourrait notamment être choisie parmi les différents types de solutions précitées : dans tous les cas, le procédé selon l'invention prévoit que la densité surfacique d'énergie des gouttelettes du spray, arrivant sur la face avant 1a du substrat SOI 1, soit inférieure ou égale à 30 Joules/m² pour limiter les endommagements mécaniques de la couche superficielle de silicium.

Préférentiellement, l'énergie cinétique surfacique des gouttelettes du spray sera choisie supérieure à 2 Joules/m², pour conserver une bonne efficacité de nettoyage de la surface du substrat.

La figure 2 présente un empilement de cartographies de face avant d'une trentaine des substrats FDSOI, après application du procédé selon le premier mode de réalisation, dans l'équipement monoplaque, et après révélation de défauts HF. Le nombre moyen de défauts HF sur chaque substrat a diminué d'environ 30 à 40% par rapport à la figure 1b, soit une amélioration significative par rapport à la séquence standard.

Au cours du procédé, la dispense d'une deuxième solution sur la face arrière 1b du substrat 1 est opérée uniquement lorsque la face avant 1a dudit substrat 1 est protégée par la dispense d'une première ou d'une troisième solution.

Le tableau 3 présente les paramètres principaux d'un deuxième mode de réalisation ne faisant pas partie de l'invention. Dans ce deuxième mode de réalisation, aucune dispense d'une deuxième solution (en face arrière 1b) n'est réalisée si la dispense d'une première ou d'une troisième solution (en face avant 1a) n'est pas en cours. Le deuxième mode de réalisation comprend en outre les paramètres optimisés de l'étape 4 énoncés dans le premier mode de réalisation.

La demanderesse a identifié que le liquide éjecté en bords du substrat 1 au niveau de la face arrière 1b (deuxième solution) pouvait être renvoyé sous forme d'éclaboussures sur la face avant 1a du substrat 1, en particulier par rebond sur les parois tronconiques du bol 40 de récupération. Lorsque la couche superficielle de silicium est nue, ces éclaboussures sont susceptibles de l'endommager mécaniquement. Un tel endommagement se traduit encore une fois par des micro-trous ou des défauts cristallins traversant la couche superficielle de silicium, et susceptibles d'induire des défauts HF.

Par contre, si la couche superficielle de silicium est couverte par une couche liquide (au cours de la dispense d'une première solution ou d'une troisième solution), les éclaboussures n'ont pas d'effet délétère sur la couche superficielle.

Selon ce deuxième mode de réalisation, les dispenses face avant (à partir de la première buse 10 ou de la troisième buse 30) et face arrière (à partir de la deuxième buse 20) sont opérées en même temps. On parle ainsi de synchronisation des dispenses. Cela implique une prise en considération du temps nécessaire pour que les dispenses soient acheminées sur chacune des faces 1a,1b au même moment, le temps nécessaire dépendant essentiellement de la longueur des conduits permettant l'approvisionnement des solutions. Cette synchronisation permet de limiter ou supprimer le temps durant lequel l'une des faces 1a,1b n'est pas protégée par l'une des solutions dispensées, limitant ainsi les risques de détérioration de la face non protégée. En synchronisant les dispenses en face avant et en face arrière, on limite également la variabilité de l'angle d'éjection des première, deuxième et/ou troisième solutions en bords de substrat 1, ce qui diminue les risques d'éclaboussures par rebond sur les parois tronconiques des bols 40.

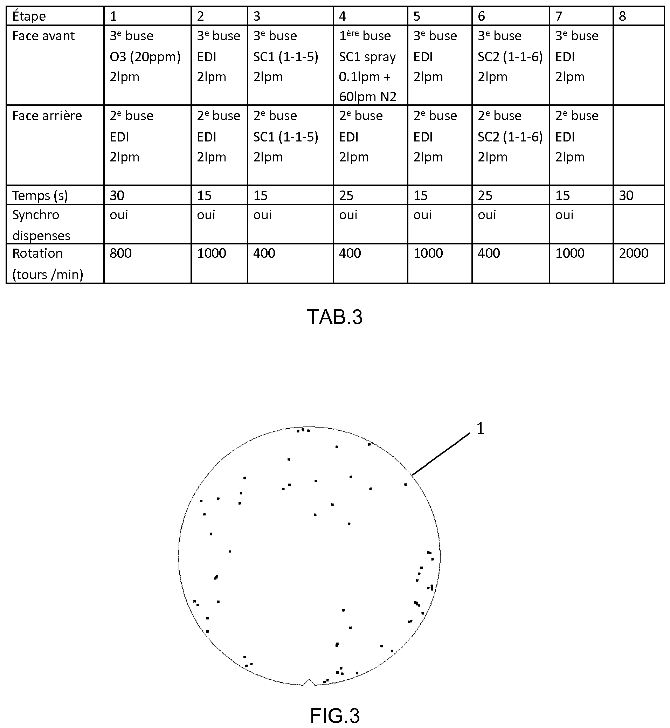

La figure 3 présente un empilement de cartographies de face avant d'une trentaine des substrats FDSOI, après application du procédé selon le deuxième mode de réalisation, dans l'équipement monoplaque, et après révélation de défauts HF. Le nombre moyen de défauts HF sur chaque plaque est diminué d'environ 20% par rapport à la figure 2 (premier mode de réalisation), soit une amélioration notable par rapport au premier mode de réalisation du procédé, et une amélioration significative par rapport à la séquence standard.

Selon une variante du deuxième mode de réalisation, la protection de la face avant 1a du substrat 1, lorsque la dispense d'une deuxième solution sur la face arrière 1b du substrat 1 est opérée, peut être réalisée par la formation d'un coussin d'azote. Préférentiellement, le coussin d'azote est formé entre la face avant du substrat SOI et une plaque écran, positionnée parallèlement à ladite face avant et à faible distance de celle-ci, typiquement de l'ordre de 1 à 2 mm ; la plaque écran est apte à expulser un flux d'azote sous pression, qui va éviter le retour de projections sur les bords du substrat 1, en face avant 1a.

De la même manière qu'une couche liquide protège la couche superficielle de silicium de l'impact des éclaboussures issues de la dispense en face arrière, une couche de gaz permet également de limiter leur effet délétère.

Au cours du procédé, le changement de position de chaque bol 40 parmi la pluralité de bols de l'équipement de nettoyage monoplaque, est opéré lorsque le mouvement de rotation du système de préhension du substrat 1 présente une vitesse inférieure ou égale à 600 tours par minute.

Le tableau 4 présente les paramètres principaux de ce troisième mode de réalisation du procédé selon l'invention. Ce troisième mode de réalisation inclut les optimisations énoncées dans les premier et deuxième modes de réalisation et inclut le fait de limiter la vitesse de rotation du substrat 1 lors des changements de position d'un bol 40. Cette limitation permet de restreindre le renvoi d'éclaboussures depuis les parois tronconiques du bol 40 vers la face avant 1a du substrat 1.

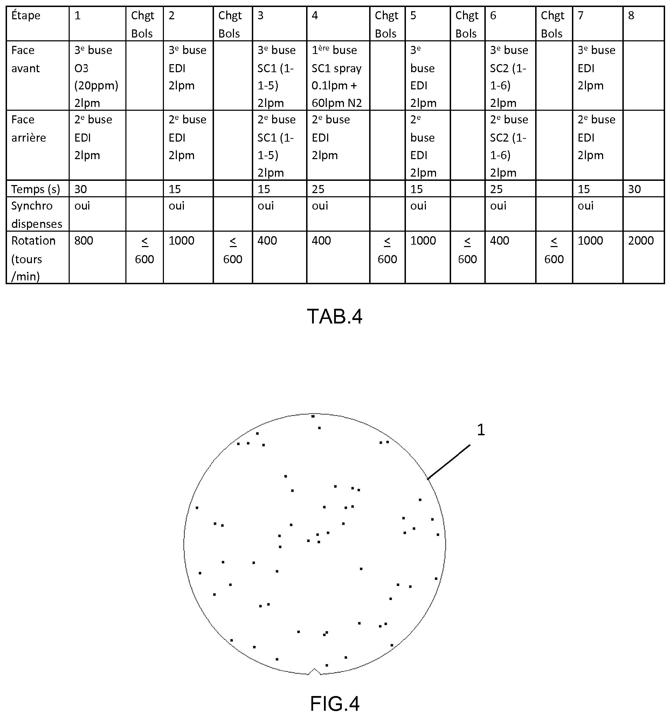

La figure 4 présente un empilement de cartographies de face avant d'une trentaine des substrats FDSOI, après application du procédé selon le troisième mode de réalisation, dans l'équipement monoplaque, et après révélation de défauts HF. Le nombre moyen de défauts HF sur chaque plaque est diminué d'environ 20% par rapport à la figure 3 (deuxième mode de réalisation), soit une amélioration notable par rapport aux premier et deuxième modes de réalisation présentés, et par rapport à la séquence standard.

Le procédé selon l'invention est particulièrement adapté au traitement de substrats SOI présentant des couches minces (silicium et oxyde) d'épaisseurs inférieures à 50nm, et en particulier des substrats dont la couche superficielle de silicium est inférieure à 20nm.

Bien entendu, l'invention n'est pas limitée aux modes de mise en oeuvre et exemples décrits, et on peut y apporter des variantes de réalisation sans sortir du cadre de l'invention tel que défini par les revendications.

## Revendications

**1.** Procédé pour le traitement d'un substrat SOI (1), dans un équipement de nettoyage monoplaque, ledit équipement comprenant :

• Un système de préhension du substrat (1) apte à opérer un mouvement de rotation,
• Une première buse (10) pour la dispense d'une première solution sous forme d'un jet de gouttelettes sur une face avant (1a) du substrat (1),
• Une deuxième buse (20) pour la dispense d'une deuxième solution sur une face arrière (1b) du substrat (1),
• Optionnellement, une plaque écran apte à être positionnée parallèlement à la face avant (1a) du substrat SOI (1) à une distance de 1 à 2 mm, et à expulser un flux d'azote sous pression pour former un coussin d'azote entre la face avant (1a) et ladite plaque écran,

La dispense de la deuxième solution sur la face arrière (1b) du substrat (1) étant opérée uniquement lorsque la face avant (1a) est protégée par la dispense d'une solution sur la face avant (1a) ou par le coussin d'azote,

Le procédé étant **caractérisé en ce que** :

- il est appliqué à un substrat SOI (1) présentant des couches minces de silicium et d'oxyde d'épaisseurs inférieures à 50nm,
- l'énergie cinétique surfacique des gouttelettes est inférieure ou égale à 30 Joules/m², (avec 30 Joules/m$^2$)
- l'équipement de nettoyage monoplaque comprend une pluralité de bols (40) de forme tronconique et disposés dans un espace périphérique au substrat (1), chaque bol (40) étant apte à changer d'altitude par rapport au substrat (1) pour récupérer au moins une des solutions après dispense lorsqu'elle est éjectée en bord dudit substrat (1), le changement d'altitude de chaque bol (40) étant opéré uniquement lorsque le mouvement de rotation du système de préhension du substrat (1) présente une vitesse inférieure ou égale à 600 tours par minute.

**2.** Procédé selon la revendication précédente, dans lequel le jet de gouttelettes est formé à partir du mélange de la première solution liquide présentant un débit compris entre 0,1 litre par minute et 0,2 litre par minute, préférentiellement entre 0,15 litre par minute et 0,2 litre par minute, et d'azote gazeux présentant un débit inférieur ou égal à 70 litres par minute, préférentiellement inférieur ou égal à 60 litres par minute.

**3.** Procédé selon l'une des revendications précédentes, dans lequel l'équipement de nettoyage monoplaque comprend une troisième buse (30) pour la dispense d'une troisième solution sous forme d'un jet liquide avec un débit compris entre 0,5 et 2,5l/min sur la face avant (1a) du substrat (1), et dans lequel la dispense de la deuxième solution sur la face arrière (1b) du substrat (1) est opérée uniquement lorsque la face avant (1a) est protégée par la dispense de la troisième solution ou de la première solution ou par le coussin d'azote.

4. Procédé selon l'une des revendications précédentes, dans lequel la dispense d'une solution sur la face arrière (1b) du substrat (1) est synchronisée avec la dispense d'une solution sur la face avant (1a) du substrat (1).

**Patentansprüche**

1. Verfahren zum Behandeln eines SOI-Substrats (1) in einer Einzelplattenreinigungsausrüstung, die Ausrüstung umfassend:

   • ein System zum Greifen des Substrats (1), das geeignet ist, eine Drehbewegung vorzunehmen,
   • eine erste Düse (10) für die Abgabe einer ersten Lösung in Form eines Tröpfchenstrahls auf eine Vorderseite (Ia) des Substrats (1),
   • eine zweite Düse (20) für die Abgabe einer zweiten Lösung auf eine Rückseite (1b) des Substrats (1),
   • optional eine Abschirmplatte, die geeignet ist, parallel zu der Vorderseite (Ia) des SOI-Substrats (1) in einem Abstand von 1 bis 2 mm positioniert zu werden und einen Stickstoffstrom unter Druck auszustoßen, um einen Stickstoffpuffer zwischen der Vorderseite (Ia) und der Abschirmplatte auszubilden,

wobei die Abgabe der zweiten Lösung auf die Rückseite (1b) des Substrats (1) nur dann vorgenommen wird, wenn die Vorderseite (Ia) durch die Abgabe einer Lösung auf die Vorderseite (Ia) oder durch den Stickstoffpuffer geschützt wird, wobei das Verfahren **dadurch gekennzeichnet ist, dass:**

   - es auf ein SOI-Substrat (1), das dünne Schichten aus Silizium und Oxid mit Dicken von weniger als 50 nm ausgeübt wird,
   - die flächenbezogene kinetische Energie der Tröpfchen kleiner als oder gleich 30 Joule/m$^2$ beträgt,
   - die Einzelplattenreinigungsausrüstung eine Vielzahl von Schalen (40), die eine kegelige Form besitzen und in einem peripheren Raum an dem Substrat (1) angeordnet sind, umfasst, wobei jede Schale (40) geeignet ist, in Bezug auf das Substrat (1) eine Höhe zu ändern, um mindestens eine der Lösungen nach der Abgabe abzufangen, wenn sie an dem Rand des Substrats (1) ausgestoßen wird, wobei die Höhenänderung jeder Schale (40) nur dann vorgenommen wird, wenn die Drehbewegung des Systems zum Greifen des Substrats (1) eine Geschwindigkeit von weniger als oder gleich 600 Umdrehungen pro Minute aufweist.

2. Verfahren nach dem vorstehenden Anspruch, wobei der Tröpfchenstrahl aus der Mischung der ersten flüssigen Lösung, die eine Ausflussmenge zwischen 0,1 Liter pro Minute und 0,2 Liter pro Minute, vorzugsweise zwischen 0,15 Liter pro Minute und 0,2 Liter pro Minute aufweist, und von gasförmigem Stickstoff, der eine Ausflussmenge von weniger als oder gleich 70 Liter pro Minute, vorzugsweise weniger als oder gleich 60 Liter pro Minute aufweist, ausgebildet ist.

3. Verfahren nach einem der vorstehenden Ansprüche, wobei die Einzelplattenreinigungsausrüstung eine dritte Düse (30) für die Abgabe einer dritten Lösung in Form eines Flüssigkeitsstrahls mit einer Ausflussmenge zwischen 0,5 und 2,5 l/min auf die Vorderseite (Ia) des Substrats (1) umfasst, und wobei die Abgabe der zweiten Lösung auf die Rückseite (1b) des Substrats (1) nur dann vorgenommen wird, wenn die Vorderseite (Ia) durch die Abgabe der dritten Lösung oder der ersten Lösung oder durch den Stickstoffpuffer geschützt ist.

4. Verfahren nach einem der vorstehenden Ansprüche, wobei die Abgabe einer Lösung auf die Rückseite (1b) des Substrats (1) mit der Abgabe einer Lösung auf die Vorderseite (Ia) des Substrats (1) synchronisiert ist.

**Claims**

1. A method for treating a SOI substrate (1), in single-wafer cleaning equipment, said equipment comprising:

   • A system for gripping the substrate (1) able to perform a rotational movement,
   • A first nozzle (10) for dispensing a first solution in the form of a jet of droplets onto a front face (1a) of the substrate (1),
   • A second nozzle (20) for dispensing a second solution onto a rear face (1b) of the substrate (1),
   • Optionally, a screen plate able to be positioned parallel to the front face (1a) of the SOI substrate (1) at a distance of 1 to 2 mm, and to expel a flow of nitrogen under pressure to form a nitrogen cushion between the front face (1a) and said screen plate,

The dispensing of the second solution onto the rear face (1b) of the substrate (1) being carried out only when the front face (1a) is protected by the dispensing of a solution onto the front face (1a) or by the nitrogen cushion, the method being **characterized in that**:

- it is applied to an SOI substrate (1) having thin layers of silicon and oxide of a thicknesses less than 50 nm,
- the surface kinetic energy of the droplets is less than or equal to 30 Joules/m$^2$,
- the single-wafer cleaning equipment comprises a plurality of cups (40) of frustoconical shape and arranged in a space peripheral to the substrate (1), each cup (40) being able to change altitude relative to the substrate (1) in order to recover at least one of the solutions after dispensing when it is ejected at the edge of said substrate (1), the change of altitude of each cup (40) being carried out only when the rotational movement of the gripping system of the substrate (1) has a speed of less than or equal to 600 revolutions per minute.

2. The method according to the preceding claim, wherein the jet of droplets is formed from the mixture of the first liquid solution having a flow rate of between 0.1 liter per minute and 0.2 liter per minute, preferably between 0.15 liter per minute and 0.2 liter per minute, and nitrogen gas having a flow rate of less than or equal to 70 liters per minute, preferably less than or equal to 60 liters per minute.

3. The method according to one of the preceding claims, wherein the single-wafer cleaning equipment comprises a third nozzle (30) for dispensing a third solution in the form of a liquid jet with a flow rate of between 0.5 and 2.5 liters per minute onto the front face (1a) of the substrate (1), and wherein the dispensing of the second solution onto the rear face (1b) of the substrate (1) is carried out only when the front face (1a) is protected by the dispensing of the third solution or the first solution or by the nitrogen cushion.

4. The method according to one of the preceding claims, wherein the dispensing of a solution onto the rear face (1b) of the substrate (1) is synchronized with the dispensing of a solution onto the front face (1a) of the substrate (1).

FIG.1a

| Étape | 1 | 2 | 3 | 4 | 5 | 6 | 7 | 8 |
|---|---|---|---|---|---|---|---|---|
| Face avant | 3e buse<br>O3<br>2lpm<br>20ppm | 3e buse<br>EDI<br>2lpm | 3e buse<br>SC1 (1-1-5)<br>2lpm | 1ère buse<br>SC1 spray<br>0.1lpm +<br>100lpm N2 | 3e buse<br>EDI<br>2lpm | 3e buse<br>SC2 (1-1-6)<br>2lpm | 3e buse<br>EDI<br>2lpm | |
| Face arrière | 2e buse<br>EDI<br>2lpm | 2e buse<br>EDI<br>2lpm | 2e buse<br>SC1 (1-1-5)<br>2lpm | 2e buse<br>EDI<br>2lpm | 2e buse<br>EDI<br>2lpm | 2e buse<br>SC2 (1-1-6)<br>2lpm | 2e buse<br>EDI<br>2lpm | |
| Temps (s) | 30 | 15 | 15 | 25 | 15 | 25 | 15 | 30 |
| Rotation (tours /min) | 800 | 1000 | 400 | 400 | 1000 | 400 | 1000 | 2000 |

TAB.1

FIG.1b

| Étape | 1 | 2 | 3 | 4 | 5 | 6 | 7 | 8 |
|---|---|---|---|---|---|---|---|---|
| Face avant | 3$^e$ buse O3 (20ppm) 2lpm | 3$^e$ buse EDI 2lpm | 3$^e$ buse SC1 (1-1-5) 2lpm | 1$^{ère}$ buse SC1 spray 0.1lpm + 60lpm N2 | 3$^e$ buse EDI 2lpm | 3$^e$ buse SC2 (1-1-6) 2lpm | 3$^e$ buse EDI 2lpm | |
| Face arrière | 2$^e$ buse EDI 2lpm | 2$^e$ buse EDI 2lpm | 2$^e$ buse SC1 (1-1-5) 2lpm | 2$^e$ buse EDI 2lpm | 2$^e$ buse EDI 2lpm | 2$^e$ buse SC2 (1-1-6) 2lpm | 2$^e$ buse EDI 2lpm | |
| Temps (s) | 30 | 15 | 15 | 25 | 15 | 25 | 15 | 30 |
| Rotation (tours /min) | 800 | 1000 | 400 | 400 | 1000 | 400 | 1000 | 2000 |

TAB.2

FIG.2

| Étape | 1 | 2 | 3 | 4 | 5 | 6 | 7 | 8 |
|---|---|---|---|---|---|---|---|---|
| Face avant | 3e buse O3 (20ppm) 2lpm | 3e buse EDI 2lpm | 3e buse SC1 (1-1-5) 2lpm | 1ère buse SC1 spray 0.1lpm + 60lpm N2 | 3e buse EDI 2lpm | 3e buse SC2 (1-1-6) 2lpm | 3e buse EDI 2lpm | |
| Face arrière | 2e buse EDI 2lpm | 2e buse EDI 2lpm | 2e buse SC1 (1-1-5) 2lpm | 2e buse EDI 2lpm | 2e buse EDI 2lpm | 2e buse SC2 (1-1-6) 2lpm | 2e buse EDI 2lpm | |
| Temps (s) | 30 | 15 | 15 | 25 | 15 | 25 | 15 | 30 |
| Synchro dispenses | oui | oui | oui | oui | oui | oui | oui | |
| Rotation (tours /min) | 800 | 1000 | 400 | 400 | 1000 | 400 | 1000 | 2000 |

TAB.3

FIG.3

| Étape | 1 | Chgt Bols | 2 | Chgt Bols | 3 | 4 | Chgt Bols | 5 | Chgt Bols | 6 | Chgt Bols | 7 | 8 |
|---|---|---|---|---|---|---|---|---|---|---|---|---|---|
| Face avant | 3e buse O3 (20ppm) 2lpm | | 3e buse EDI 2lpm | | 3e buse SC1 (1-1-5) 2lpm | 1ère buse SC1 spray 0.1lpm + 60lpm N2 | | 3e buse EDI 2lpm | | 3e buse SC2 (1-1-6) 2lpm | | 3e buse EDI 2lpm | |
| Face arrière | 2e buse EDI 2lpm | | 2e buse EDI 2lpm | | 2e buse SC1 (1-1-5) 2lpm | 2e buse EDI 2lpm | | 2e buse EDI 2lpm | | 2e buse SC2 (1-1-6) 2lpm | | 2e buse EDI 2lpm | |
| Temps (s) | 30 | | 15 | | 15 | 25 | | 15 | | 25 | | 15 | 30 |
| Synchro dispenses | oui | | oui | | oui | oui | | oui | | oui | | oui | |
| Rotation (tours /min) | 800 | ≤ 600 | 1000 | ≤ 600 | 400 | 400 | ≤ 600 | 1000 | ≤ 600 | 400 | ≤ 600 | 1000 | 2000 |

TAB.4

FIG.4

**EP 3 624 169 B1**

**Documents brevets cités dans la description**

- US 2002062840 A1
- US 2012160275 A1
- US 2005115671 A1

**Littérature non-brevet citée dans la description**

- **M.SATO et al.** Analysis on threshold energy of particle removal in spray cleaning technology. *ECS Transactions,* 2011, vol. 41 (5), 75-82